# EUROPÄISCHE PATENTANMELDUNG

(11) **EP 2 525 493 A1**
(43) Veröffentlichungstag der Anmeldung: **21.11.2012**
(21) Anmeldenummer: 12167391.7
(22) Anmeldetag: 09.05.2012
(51) Int. Cl.: H03K 17/975, H03K 17/98

(54) **Bedieneinrichtung für ein Elektrogerät und Elektrogerät**

(30) Priorität: 16.05.2011 DE 102011075942
(71) Anmelder: E.G.O. ELEKTRO-GERÄTEBAU GmbH, 75038 Oberderdingen (DE)
(72) Erfinder: Richter, Andreas, 74211 Leingarten (DE)
(74) Vertreter: Patentanwälte Ruff, Wilhelm, Beier, Dauster & Partner

(57) **Zusammenfassung**

Bei einer Bedieneinrichtung für ein Elektrogerät bzw. ein Haushaltsgerät erfolgt die Bedienung durch Drücken auf ein elastisches Bedien-Feld mit einem kapazitiven Sensorelement darunter, das eine elektrisch leitfähige untere Sensor-Fläche als untere Kondensatorplatte aufweist. Darüber ist das Bedien-Feld vorgesehen und dazwischen eine Dielektrikums-Schicht. Die untere Sensor-Fläche sowie eine darüber angeordnete Kondensatorplatte sind jeweils an üblichen Leiterplatten ausgebildet. Es erfolgt eine Messung der Kapazität zwischen den beiden Kondensatorplatten. Direkt auf der oberen Leiterplatte ist eine weitere Auflage als Bedien-Feld vorgesehen.

## Beschreibung

Die Erfindung betrifft eine Bedieneinrichtung für ein Elektrogerät sowie ein damit versehenes Elektrogerät.

Aus der WO 2005/067146 A ist es bekannt, eine Bedieneinrichtung für ein Elektrogerät für eine Bedienung durch Drücken auf ein formveränderliches oder elastisches Bedien-Feld mit einem kapazitiven Sensorelement darunter so auszugestalten, dass das Bedien-Feld eine einzige durchgehende Metallfläche ist bzw. Teil einer solchen. Dabei sind auch zu dem kapazitiven Sensorelement hin keine weiteren Bauteile vorgesehen. An der Vorderseite kann dies, beispielsweise im Fall eines Edelstahlblechs, eine optisch ansprechende leicht reinigbare Gestaltung ergeben. Das Annähern des eingedrückten metallischen Bedien-Feldes an das kapazitive Sensorelement kann von einer Steuerung erkannt werden und als Bedien-Befehl ausgewertet werden. Das metallische Bedien-Feld ist natürlich gegenüber dem Sensorelement elektrisch isoliert.

### Aufgabe und Lösung

Der Erfindung liegt die Aufgabe zugrunde, eine eingangs genannte Bedieneinrichtung sowie ein damit versehenes Elektrogerät zu schaffen, mit denen Probleme des Standes der Technik gelöst werden können und insbesondere eine einfachere Konstruktion bzw. Herstellung mit geringerem Aufwand möglich ist.

Gelöst wird diese Aufgabe durch eine Bedieneinrichtung mit den Merkmalen des Anspruchs 1 sowie ein Elektrogerät mit den Merkmalen des Anspruchs 14. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht.

Es ist vorgesehen, dass bei der Bedieneinrichtung die Bedienung durch Drücken auf ein formveränderliches oder elastisches Bedien-Feld erfolgt, unter dem ein kapazitives Sensorelement angeordnet ist. Das Sensorelement ist als eine elektrisch leitfähige untere Sensor-Fläche ausgebildet, welche eine untere Kondensatorplatte bildet. Mit etwas Abstand und parallel dazu ist über dem Sensorelement das Bedien-Feld vorgesehen bzw. ein flächiges Bauteil, von dem das Bedien-Feld ein Teil ist. Dazwischen befindet sich mindestens eine Dielektrikums-Schicht.

Erfindungsgemäß ist die elektrisch leitfähige untere Sensor-Fläche an einer üblichen Leiterplatte mit einem isolierenden Träger und einer Metallschicht darauf ausgebildet bzw. wird davon gebildet. Die Metallschicht ist in getrennte Flächen sowie Leiterbahnen strukturiert, wobei die Leiterbahnen unter anderem dazu vorgesehen sein können, die Flächen bzw. die Sensor-Flächen an eine Steuerung odgl. anzuschließen. Mit Abstand und parallel zu der unteren Leiterplatte ist darüber eine obere Leiterplatte vorgesehen, die ebenfalls eine übliche Standard-Leiterplatte ist mit einem isolierenden Träger und einer Metallschicht darauf. Diese obere Metallschicht, die vorzugsweise im Wesentlichen durchgängig sein kann, bildet die andere Kondensatorplatte. So kann die Kapazität zwischen den beiden Kondensatorplatten gemessen werden und eine Kapazitätsänderung beim Drücken auf das Bedien-Feld mit Annäherung der Kondensatorplatten aufeinander zu und einer entsprechenden Kapazitätsänderung bzw. Kapazitätszunahme als Bedien-Befehl gewertet werden. Direkt auf der oberen Leiterplatte ist nach oben zu mindestens eine weitere Auflage als Bedien-Feld bzw. Bedien-Oberfläche, die das Bedien-Feld aufweist, vorgesehen. Dies kann, wie aus dem eingangs genannten Stand der Technik bekannt ist, eine metallische Auflage sein, beispielsweise eine Metallfolie bzw. Edelstahlfolie. Es können auch sonstige Auflagen oder Schichten sein, die lediglich ausreichend formveränderlich bzw. elastisch sein müssen, um ein Eindrücken am Bedien-Feld noch zu ermöglichen.

Das Spezielle und der Vorteil bei dieser Erfindung liegt also darin, dass die Bedieneinrichtung im Wesentlichen aus zwei Leiterplatten aufgebaut werden kann, wobei hier eine Leiterplatte nicht im Sinne eines flächigen Trägers mit irgendwelchen Leiterbahnen darauf in allgemeiner Form zu verstehen ist, sondern als Leiterplatte, wie sie üblicherweise und bekanntermaßen im Elektronikbereich verwendet wird. Diese Leiterplatten weisen einen Leiterplattenträger aus üblicherweise mit Kunstharz getränktem Fasermaterial auf, auf dem zuerst eine vollflächige Kupferschicht aufgebracht ist, die dann durch übliche Verfahren mittels Belichten und Ätzen odgl. strukturiert wird entsprechend einer vorgegebenen Belichtungsmaske. Des Weiteren können solche Leiterplatten auch für die Verwendung in der erfindungsgemäßen Bedieneinrichtung Löcher oder Durchbrüche aufweisen sowie zweiseitig mit Leiterbahnen bzw. Kupfer beschichtet sein. Unter Umständen können auch Durchkontaktierungen vorgesehen sein, gerade von als Sensor-Flächen dienenden Flächen auf der Oberseite der unteren Leiterplatte an deren Unterseite und dann mittels Leiterbahnen an eine elektrische Verschaltung oder eben eine Steuerung. Der Vorteil der Verwendung solcher üblicher Leiterplatten liegt darin, dass diese sehr günstig herzustellen sind, quasi überall verfügbar sind und eben auch in bewährten Verfahren großserientechnisch und günstig hergestellt werden können.

In Ausgestaltung der Erfindung kann die Metall- bzw. Kupferschicht an der oberen Leiterplatte im Wesentlichen durchgehend und geschlossen sein. So bildet sie quasi eine einzige Kondensatorplatte als Gegenstück für alle unteren Kondensatorplatten. Zumindest sollte die obere Schicht in den Bereichen über den unteren Sensor-Flächen durchgehend sein. Somit ist der elektrische Anschluss an die obere Kondensatorplatte sehr einfach, es braucht nämlich nur ein einziger solcher Anschluss für alle Berührschalter vorgesehen werden. Diese Berührschalter werden durch je eine Paarung der oberen Kondensatorplatte und einer unteren Kondensatorplatte bereitgestellt. Bei einer gemeinsamen oberen Kondensatorplatte werden die Berührschalter im Wesentlichen durch die unteren Sensor-Flächen bzw. unteren Kondensatorplatten definiert.

Zwischen der unteren Leiterplatte und der oberen Leiterplatte sind vorteilhaft isolierende Abstandshalter vorgesehen. Diese halten also die beiden Leiterplatten auseinander in einem definierten Abstand und parallel zueinander. Dabei kann ein solcher Abstandshalter als Folie oder Platte ausgebildet sein, in denen Ausschnitte bzw. Ausnehmungen vorgesehen sind in den Bereichen der unteren Sensor-Flächen, so dass der Abstandshalter außerhalb der wesentlichen Fläche der unteren Sensor-Fläche verläuft bzw. nur an deren Randbereichen. Insbesondere sind die Ausnehmungen etwas kleiner als die unteren Sensor-Flächen. So können die überwiegenden Mittenbereiche und somit der überwiegende Teil ihrer Fläche ohne Überdeckung sein, so dass sich hier die obere Leiterplatte eindrücken lässt. Durch einen einzigen durchgehenden und zusammenhängenden Abstandshalter sind Montage und Aufbau auch sehr einfach.

Wie zuvor angesprochen worden ist, erfolgt durch Drücken auf das Bedien-Feld bzw. den dort vorgesehenen Berührschalter eine Kapazitätsänderung, welche vorteilhaft eine Kapazitätszunahme ist, indem sich die Metallschicht an der oberen Leiterplatte der unteren Sensor-Fläche annähert. Dies kann von einer mit dieser unteren Sensor-Fläche verbundenen Steuerung erfasst werden als Bedienung bzw. in einen Bedien-Befehl umgesetzt werden. Das zwischen den Kondensatorplatten bzw. - flächen befindliche Dielektrikum kann vorteilhaft Luft sein, da dann keine weiteren konstruktiven Maßnahmen notwendig sind. Alternativ kann es auch eine leicht kompressible Folie mit einer bestimmten bzw. hohen Dielektrizitätskonstante ε sein.

Vorteilhaft sind sämtliche unteren Sensor-Flächen mittels Leiterbahnen in derselben Schichtebene mit einer Steuerung verbunden. Dies bedeutet, dass sowohl die Sensor-Flächen als auch die zur Verbindung dienenden Leiterbahnen aus derselben Metallschicht gefertigt sind und somit die Leiterplatte einschichtig ist auf jeder Seite. So ist der Herstellungsprozess für die Leiterplatte einfacher. Dies gilt auch für die obere Leiterplatte, wenngleich hier weniger Strukturierung notwendig ist, da eine Unterteilung in die einzelnen Sensor-Flächen eben nicht zwingend notwendig ist. Nachträgliche Strukturierungsschritte nach dem üblichen Leiterplattenprozess mit Strukturierung müssen nicht vorgesehen sein, zumindest nicht bezüglich der Metallschichten.

Ein Abstand der beiden Leiterplatten zueinander kann relativ gering sein und zwischen den Metallschichten etwa 50 µm bis 200 µm betragen, vorteilhaft auch etwas weniger bzw. knapp 50 µm. Unter Umständen kann es auch etwas mehr sein, wobei dies allgemein davon abhängt, wie die gesamte Bedieneinrichtung aufgebaut ist und um welches Maß ein Bedien-Feld bei einer üblichen Bedienung durch Drücken darauf eingedrückt wird.

Unter Umständen können an der unteren Leiterplatte auch noch weitere Leiterplatten als Sandwich-Bauweise angesetzt sein. Dies betrifft aber die Funktionalität der Bedieneinrichtung nicht, insbesondere nicht im Hinblick auf die obere Leiterplatte mit den den Sensor-Flächen gegenüberliegenden Metallschichten.

Vorteilhaft sind die beiden Leiterplatten als sogenannter Multilayer-Aufbau bzw. Multilayer-Leiterplatte ausgebildet, ggf. mit den vorgenannten weiteren Leiterplatten zusammen. Besonders vorteilhaft sind sie dabei miteinander verbunden, insbesondere verklebt, zu einer unlösbaren Baueinheit. Bei einem Multilayer-Aufbau kann deren einzelne Dicke allgemein ziemlich gering sein, beispielsweise 0,1 mm bis 0,3 mm. Die Dicke des gesamten Schichtenpakets kann unter 2 mm liegen oder sogar unter 1 mm. Eine Bedieneinrichtung mit Multilayer-Aufbau kann mit den vorbeschriebenen Schritten des Aufbaus der beiden leitfähigen Schichten und fertig strukturierten Zwischenschicht bzw. der Abstandshalter-Schicht dazwischen mit im wesentlichen den üblichen Schritten aufgebaut werden, so dass der kapazitive Sensor enthalten ist, und dann für den Einbau in ein Elektrogerät bzw. Haushaltsgerät angeliefert und eingebaut werden.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombination bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ein Ausführungsbeispiel der Erfindung ist in den Zeichnungen schematisch dargestellt und wird im Folgenden näher erläutert. In den Zeichnungen zeigen:
- Fig. 1: einen Schnitt durch eine erfindungsgemäße Bedieneinrichtung für ein Elektrogerät mit Anordnung zweier Leiterplatten zueinander und einer weiteren Auflage darauf,
- Fig. 2: eine Draufsicht auf die untere Leiterplatte mit der Strukturierung in einzelne Sensor-Flächen und
- Fig. 3: eine Bedieneinrichtung entsprechend Fig. 1, bei der auf ein Bedien-Feld gedrückt wird.

### Detaillierte Beschreibung des Ausführungsbeispiels

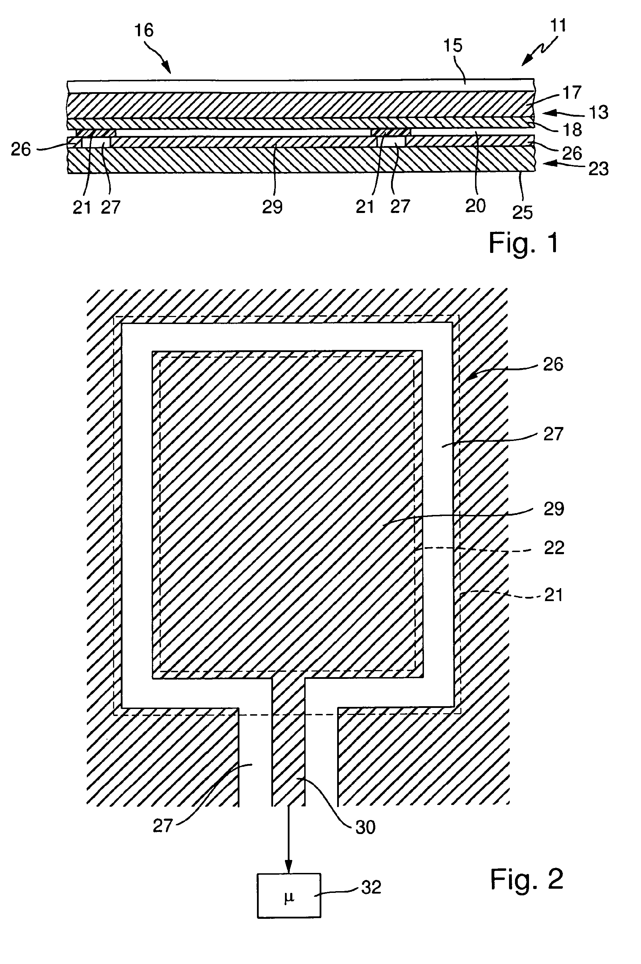

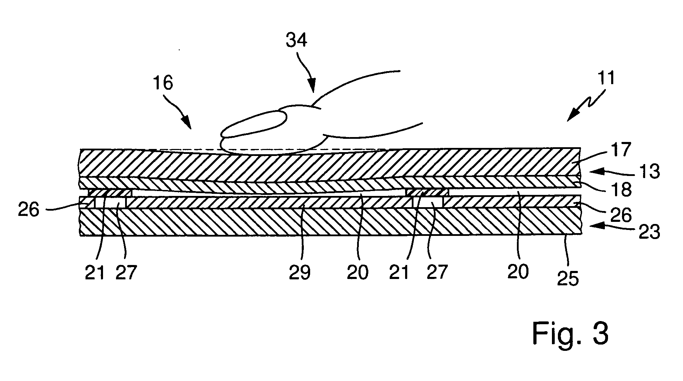

In Fig. 1 ist im Schnitt eine erfindungsgemäße Bedieneinrichtung 11 dargestellt, wie sie beispielsweise unter einer Blende in einem Elektrogerät eingebaut sein kann. Eine solche Blende kann beispielsweise ein metallischer Rahmen eines Glaskeramik-Kochfeldes sein, eine Front einer Geschirrspülmaschine oder auch eines Backofens. Die Bedieneinrichtung 11 weist eine obere Leiterplatte 13 und eine untere Leiterplatte 23 auf, wobei auf der Oberseite der oberen Leiterplatte 13 eine Edelstahlfolie 15 als Auflage bzw. Oberfläche der Bedieneinrichtung 11 vorgesehen ist. Vorteilhaft ist sie aufgeklebt. Sie kann Prägungen, Beschriftungen odgl. aufweisen, insbesondere um ein Bedien-Feld 16 zu kennzeichnen. Alternativ zur Edelstahlfolie kann auch ein dünnes Edelstahlblech vorgesehen sein, welches vorteilhaft eine Dicke von weniger als 2 mm aufweist, besonders vorteilhaft weniger als 1 mm. Dabei wird an dem Bedien-Feld 16 ein Berührschalter gebildet, wie nachfolgend noch näher erläutert wird. Auf dieses Bedien-Feld 16 kann, wie Fig. 3 später zeigt, ein Finger aufgelegt werden zur Bedienung.

Die obere Leiterplatte 13 weist an einem üblichen isolierenden Träger 17 eine Metallschicht 18 auf, welche vorteilhaft durchgängig bzw. geschlossen ausgebildet ist und im Wesentlichen den gesamten Träger 17 bedeckt. Die Metallschicht 18 muss keinen elektrischen Anschluss haben, da für die hier beschriebene Funktion die Kupferfläche alleine schon ausreicht. Ein Anschluss kann aber dazu dienen, die Störsicherheit zu erhöhen. Durch einen Luftspalt 20 getrennt befindet sich unter der oberen Leiterplatte 13 die untere Leiterplatte 23 mit einem entsprechenden Träger 25 mit einer Metallschicht 26 darauf. Diese Metallschicht 26 jedoch ist durch eine Strukturierung bzw. einen Graben 27 strukturiert und bildet so, wie die Draufsicht aus Fig. 2 zeigt, eine untere Sensorfläche 29. Von dieser unteren Sensorfläche 29 geht eine Leiterbahn 30 ab zu einer nicht im Detail dargestellten Steuerung 32. Auch die Leiterbahn 30 wird aus der unteren Metallschicht 26 im Wesentlichen durch eine Strukturierung bzw. den Graben 27 herausgebildet.

Auch wenn in der allgemeinen Beschreibung sowie in der Figurenbeschreibung die strukturierte Kupferfläche bzw. die Sensorschichten auf der Oberseite der unteren Leiterplatte angeordnet sind, so könnten sie grundsätzlich auch umgekehrt an der Unterseite der oberen Leiterplatte angeordnet sein. Dann muss unter Umständen die elektrische Isolierung zum Bedien-Feld verbessert werden, was aber grundsätzlich kein Problem ist.

Um den genannten Luftspalt 20 genau einzuhalten, ist ein Abstandshalter 21 vorgesehen, der in Fig. 2 in der Draufsicht gestrichelt dargestellt ist. Er ist hier zwar eher gitterartig, kann jedoch insgesamt auch im Wesentlichen flächig sein, beispielsweise eine Folie oder eine Beschichtung, mit einem Ausschnitt 22 darin, der etwas kleiner ist als die untere Sensor-Fläche 29, sich also zur Seite hin weiter ausdehnen. Im Falle eines Multilayer-Aufbaus kann die Beschichtung eine dort übliche isolierende Beschichtung bzw. Isolierung sein, nur eben mit Ausnehmungen 20 darin. Der Abstandshalter 21 kann auch in den Gräben 27 angeordnet sein, dann aber mit größerer Höhe als die Metallschicht der unteren Sensor-Fläche 29. Wie aus Fig. 1 zu ersehen ist, liegt der Abstandshalter 21 den Graben 27 überdeckend auf der unteren Metallschicht 26 auf und stellt so beim Drücken auf das Bedien-Feld sicher, dass nur über der entsprechenden unteren Sensorfläche 29 bzw. innerhalb des Ausschnitts 22 eine Annäherung der oberen Metallschicht 18 an die untere Sensor-Fläche 29 erfolgt. Die Steuerung 32 eine kann Kapazitätsänderung zwischen der oberen Metallschicht 18 und einer untere Sensorfläche 29 bzw. allgemein an der unteren Sensorfläche 29 erkennen durch deren Anschluss an die Steuerung 32.

In Fig. 3 ist dargestellt, wie auf eine Bedieneinrichtung 11 entsprechend Fig. 1 am Bedien-Feld 16 ein Finger 34 mit Druck aufgelegt wird. Dadurch biegt sich die obere Leiterplatte 13, natürlich samt hier nicht dargestellter Auflage bzw. Edelstahlfolie, ein Stück nach unten durch. Diese Durchbiegung beträgt die Differenz zum darüber gestrichelt dargestellten ursprünglichen Verlauf und kann beispielsweise 25 µm bis 50 µm oder sogar 100 µm betragen. Dabei sollte jedoch bei Konstruktion der Bedieneinrichtung 11 vermieden werden, dass die obere Metallschicht 18 die untere Metallschicht 26 bzw. die untere Sensorfläche 29 direkt berührt. Zwar könnte dies eine Steuerung 32 auch entsprechend erkennen und dann definitiv als Bedien-Befehl auswerten. Eine Fehlermeldung in diesem Fall wird aber bevorzugt, da eine solche starke Durchbiegung auf eine eklatante Fehlbedienung schließen lässt und dies nur als Fehler interpretiert werden sollte. In diesem Fall kann aber eine Beschädigung der Bedieneinrichtung 11 nicht unbedingt vermieden werden.

Der Luftspalt 20, auch gemäß Fig. 1, beträgt zwischen 50 µm und 200 µm, kann aber auch etwas kleiner sein. In Fig. 3 ist zu ersehen, dass dieser Luftspalt durch das Drücken des Fingers 34 verringert wird, so dass sich eine signifikante und gut erkennbare Kapazitätsänderung an dem zwischen oberer Metallschicht 18 und unterer Sensor-Fläche 29 gebildeten Kondensator ergibt. Diese kann dann die Steuerung 32 entsprechend auswerten. Die Verringerung kann etwa 10% bis 30% betragen, was ausreicht für eine sichere Erkennung.

Es ist möglich, dass gleich neben dem dargestellten Bedien-Feld 16 als Berührschalter ein weiteres Bedien-Feld 16 vorgesehen wird, beispielsweise direkt auf der anderen Seite des Abstandshalters 21 entsprechend Fig. 2. Dann kann ein solcher Abstandshalter im Wesentlichen netz- oder gitterartig ausgebildet sein, aber immer noch eine größere Fläche überdecken. Dies ist aber eine einfache konstruktive Ausgestaltung je nach entsprechender Anforderung.

Angesichts der Strukturierung der unteren Leiterplatte 23 entsprechend Fig. 2 ist leicht vorstellbar, wie auf relativ einfache Art und Weise mittels eines üblichen Leiterplatten-Herstellungsverfahrens mit einem Ätz-/Strukturierungsprozess die Strukturierung der Metallschicht 26 mit Herausarbeiten der unteren Sensorfläche 29 und der Leiterbahn 30 erfolgen kann. Ebenso kann dann in einem üblichen Beschichtungsverfahren, wie es für Multilayer-Leiterplatten üblich ist, eine isolierende Zwischenschicht aufgebracht werden, allerdings eben nicht wie üblich flächig durchgängig, sondern mit den Luftspalten 20 zwischen den Abstandshaltern 21. Dies erfolgt vorteilhaft auch in einem einzigen Schritt bzw. Beschichtungsschritt.

Die Dicke der Träger 17 und 25 kann allgemein maximal wenige Millimeter betragen, üblicherweise 1 mm bis 2 mm. Bei einem Multilayer-Aufbau kann sie allgemein deutlich geringer sein, beispielsweise 0,1 mm bis 0,3 mm. Als Material kann eine mit Epoxidharz getränkte Glasfasermatte, Materialkennung FR4, verwendet werden. Dies kann, abhängig vom Einsatzort der Bedieneinrichtung, auch eine wärmebeständige Ausführung FR5 sein. Als Alternative kann das Epoxidharz durch ein Phenolharz ersetzt werden bzw. das Glasfasergewebe durch Papier. Des Weiteren kann unter Umständen auch ein üblicherweise verwendeter Lötstopplack noch über den Metallschichten verlaufen. Für den Abstandshalter 21 kann eine übliche isolierende Kunststofffolie verwendet werden. Des Weiteren ist es angesichts der Darstellung in Fig. 1 leicht vorstellbar, wie zumindest die untere Leiterplatte 23 auch als doppelseitige, durchkontaktierte Leiterplatte ausgebildet sein kann, beispielsweise um an der Unterseite den größeren vorhandenen Bauraum für eine Bauteilbestückung zu nutzen.

Die Metallschichten 18 und 26 bestehen wie üblich aus Kupfer. Des Weiteren ist es möglich, die Bedieneinrichtung 11 bestehend aus den Leiterplatten 13 und 23 sowie dem Abstandshalter 21 miteinander zu verkleben, um eine definierte Anordnung sowie eine leicht verarbeitbare bzw. einbaubare Baueinheit zu erhalten. Diese bildet quasi die Sensorerfassung und muss dann nur noch mit entsprechenden elektrischen Kontakten, zu denen beispielsweise die Leiterbahnen 30 führen können, angeschlossen werden, insbesondere an eine Steuerung 32.

## Patentansprüche

1. Bedieneinrichtung für ein Elektrogerät, vorzugsweise ein Haushaltsgerät, wobei die Bedienung durch Drücken auf ein formveränderliches oder elastisches Bedien-Feld mit einem kapazitiven Sensorelement darunter erfolgt, wobei das Sensorelement eine elektrisch leitfähige untere Sensor-Fläche als eine untere Kondensatorplatte aufweist, wobei darüber das Bedien-Feld vorgesehen ist und dazwischen mindestens eine Dielektrikums-Schicht angeordnet ist, **dadurch gekennzeichnet, dass** die elektrisch leitfähige untere Sensor-Fläche an einer üblichen Leiterplatte mit einem isolierenden Träger und einer Metallschicht ausgebildet ist, die in getrennte Flächen sowie Leiterbahnen darauf strukturiert ist, wobei mindestens eine der Flächen die untere Sensor-Fläche bildet, und wobei mit Abstand über der unteren Leiterplatte eine parallele obere Leiterplatte mit einem isolierenden Träger und einer Metallschicht darauf als übliche Leiterplatte angeordnet ist, wobei die Metallschicht die andere Kondensatorplatte bildet zur Messung der Kapazität zwischen den beiden Kondensatorplatten, und wobei auf der oberen Leiterplatte mindestens eine weitere Auflage als Bedien-Feld vorgesehen ist.

2. Bedieneinrichtung nach Anspruch 1, **dadurch gekennzeichnet, dass** die Metallschicht an der oberen Leiterplatte durchgehend und geschlossen ist, insbesondere derart, dass sämtliche unteren Sensor-Flächen von einer einzigen durchgängigen Metallschicht an der oberen Leiterplatte überdeckt werden.

3. Bedieneinrichtung nach Anspruch 2, **dadurch gekennzeichnet, dass** die Metallschicht an der oberen Leiterplatte zumindest in den Bereichen über den unteren Sensor-Flächen durchgehend und geschlossen ist.

4. Bedieneinrichtung nach einem der vorhergehenden Ansprüche, **dadurch gekennzeichnet, dass** zwischen der unteren Leiterplatte und der oberen Leiterplatte isolierende Abstandshalter vorgesehen sind.

5. Bedieneinrichtung nach Anspruch 4, **dadurch gekennzeichnet, dass** die isolierenden Abstandshalter außerhalb der hauptsächlichen Flächen der unteren Sensor-Flächen bzw. nur an deren Randbereichen außerhalb der überwiegenden Mittenbereiche vorgesehen sind.

6. Bedieneinrichtung nach einem der vorhergehenden Ansprüche, **dadurch gekennzeichnet, dass** als Abstandshalter ein flächiges elektrisch isolierendes Material verwendet wird mit Ausnehmungen im Bereich der unteren Sensor-Flächen.

7. Bedieneinrichtung nach Anspruch 6, **dadurch gekennzeichnet, dass** die Ausnehmungen etwas kleiner sind als die unteren Sensor-Flächen.

8. Bedieneinrichtung nach einem der vorhergehenden Ansprüche, **dadurch gekennzeichnet, dass** ein Abstand der beiden Leiterplatten bzw. der Metallschichten zueinander zwischen 50 µm und 200 µm beträgt.

9. Bedieneinrichtung nach einem der vorhergehenden Ansprüche, **dadurch gekennzeichnet, dass** durch Drücken auf das Bedien-Feld eine Kapazitätsänderung bzw. Kapazitätszunahme erfolgt zwischen der Metallschicht an der oberen Leiterplatte und derjenigen unteren Sensor-Fläche an der unteren Leiterplatte, über der auf das Bedien-Feld gedrückt wird, wobei die Kapazitätsänderung bzw. Kapazitätszunahme durch die Annäherung der Metallschicht der oberen Leiterplatte und der unteren Sensor-Fläche erfolgt und von einer mit der unteren Sensor-Fläche verbundenen Steuerung erfassbar ist.

10. Bedieneinrichtung nach einem der vorhergehenden Ansprüche, **dadurch gekennzeichnet, dass** die unteren Sensor-Flächen mittels Leiterbahnen in derselben Schichtebene mit einer Steuerung verbunden sind und die obere Metallschicht ebenso.

11. Bedieneinrichtung nach einem der vorhergehenden Ansprüche, **dadurch gekennzeichnet, dass** die untere Leiterplatte in einem üblichen Ätz-/Strukturierungsprozess mit einer einzigen Metallschicht auf der Oberseite hergestellt worden ist ohne weitere nachträgliche Strukturierungsschritte odgl., vorzugsweise die obere Leiterplatte ebenso.

12. Bedieneinrichtung nach einem der vorhergehenden Ansprüche, **dadurch gekennzeichnet, dass** die beiden Leiterplatten als MultiLayer-Aufbau ausgebildet sind mit uU weiteren Leiterplatten zusammen.

13. Bedieneinrichtung nach Anspruch 12, **dadurch gekennzeichnet, dass** die beiden Leiterplatten miteinander verbunden sind, insbesondere verklebt, zu einer unlösbaren Baueinheit.

14. Elektrogerät, insbesondere Haushaltsgerät, **dadurch gekennzeichnet, dass** es eine Bedieneinrichtung nach einem der vorhergehenden Ansprüche aufweist.

15. Elektrogerät nach Anspruch 14, **dadurch gekennzeichnet, dass** die Bedieneinrichtung in einem Bedien-Bereich vorgesehen ist.
